# EUROPEAN PATENT APPLICATION

(11) **EP 4 443 693 A1**
(43) Date of publication of application: **09.10.2024**
(21) Application number: 22951383.3
(22) Date of filing: 18.07.2022
(51) Int. Cl.: H02J 7/00

(54) **BATTERY EQUALIZATION TESTING METHOD AND APPARATUS, AND ELECTRONIC DEVICE AND STORAGE MEDIUM**

(71) Applicant: Contemporary Amperex Technology (Hong Kong) Limited, Central, Central And Western District (HK)
(72) Inventor: PENG, Lei, Ningde, Fujian 352100 (CN); ZHOU, Meijuan, Ningde, Fujian 352100 (CN); ZHANG, Shichang, Ningde, Fujian 352100 (CN)
(74) Representative: Ziebig Hengelhaupt Intellectual Property Attorneys Patentanwaltskanzlei PartGmbB
(86) International application number: PCT/CN2022/106213
(87) International publication number: WO 2024/016104

(57) **Abstract**

A battery balancing detection method, apparatus, an electronic device, and a storage medium, wherein the method comprises: performing negative pulse discharging on a battery in response to a battery balancing detection instruction; and determining an unbalancing degree of the battery based on electrical parameters of battery cells in the battery after discharging. The method can avoid detection errors brought about by DCR when detecting the unbalancing degree in the case where current exists when the power battery system is providing electric energy, and can take into account the detection of the unbalancing degree of the battery while detecting the SOH of the battery by means of negative pulses, which is conducive to the improvement of the energy utilization rate and the service life of the battery.

## Description

### Technical Field

The present application relates to the field of batteries, and specifically to a battery balancing detection method and apparatus, an electronic device, and a storage medium.

### Background

The performance of the power battery system, as the core component of a new energy vehicle, directly affects the performance of the whole vehicle. Here, the inconsistency of the battery pack in the power battery system is an important factor that leads to the degradation of battery performance. The inconsistency of the battery pack is usually caused by the difference in the state of charge (SOC) between battery cells, and an unbalanced battery pack reduces the capacity and energy utilization of the battery pack, thus lowering the input and output power level of the battery pack, and also shortens the service life of the battery pack. In order to improve the consistency of the battery pack during use, the battery pack needs to be balanced according to the unbalancing degree between the battery cells.

In the related art, the unbalancing degree of a battery is identified by determining a voltage difference of the power battery system, but in the case where a current exists when the power battery system is providing electric energy, the voltage difference may be due to a difference in direct current resistance (DCR) and not only due to a difference in SOC between the battery cells; therefore, the above solution results in a low accuracy of detection of the battery unbalancing degree in the power battery system.

### Summary of the Invention

In view of the above problem, the present application provides a battery balancing detection method and apparatus, an electronic device, and a storage medium, which are capable of solving the technical problem of low accuracy of detection of the unbalancing degree during the use of the battery.

In a first aspect, the present application provides a battery balancing detection method, comprising: performing negative pulse discharging on a battery in response to a battery balancing detection instruction; and determining an unbalancing degree of the battery based on electrical parameters of battery cells in the battery after discharging.

In the technical solution of embodiments of the present invention, negative pulse discharging is performed on a battery and an unbalancing degree of the battery is determined based on electrical parameters of battery cells in the battery after the discharging, which can avoid detection errors brought about by DCR during the detection of the unbalancing degree in the case where a current exists when the power battery system is providing electric energy, thereby improving the accuracy of detection of the battery unbalancing degree.

In some embodiments, said performing negative pulse discharging on a battery comprises: performing negative pulse discharging of the battery to discharge the battery from a current state of charge (SOC) to a target SOC. In this embodiment, the detection of the balancing degree can be performed on different types of batteries quickly and flexibly by discharging the current SOC of the battery to a preset target SOC by means of negative pulses. This detection method has low limitations and has a high general applicability.

In some embodiments, the battery is a battery-with-platform, the slope of an SOC-open circuit voltage (OCV) curve corresponding to the battery-with-platform containing an interval having a zero slope; and said performing negative pulse discharging of the battery to discharge the battery from a current state of charge (SOC) to a target SOC comprises: determining as the target SOC any SOC that is less than the current SOC of the battery within an SOC interval of the curve that has a non-zero slope; and reducing an SOC of the battery to the target SOC based on negative pulses.

In this embodiment, when detecting the balancing degree of a battery-with-platform, the unbalancing degree of the battery can be accurately detected by discharging the SOC of the battery of this type to the SOC interval in which the slope of the SOC-OCV curve is non-zero without discharging the battery of this type to the low end, thus avoiding the phenomenon of breaking down of the vehicle.

In some embodiments, the battery is a battery-without-platform, the slope of an SOC-OCV curve corresponding to the battery-without-platform not containing an interval having a zero slope; and said performing negative pulse discharging of the battery to discharge the battery from a current state of charge (SOC) to a target SOC comprises:
selecting as the target SOC any SOC that is less than the current SOC of the battery from an SOC interval constituted by a maximum SOC and a minimum SOC of an operating condition of an electrical device during a first preset duration; and
reducing an SOC of the battery to the target SOC based on negative pulses.

In this embodiment, when detecting the balancing degree of a battery-without-platform, the balancing degree can be detected by discharging the SOC of the battery of this type to the SOC interval corresponding to the operating condition of the electrical device without discharging the battery of this type to the low end, which can not only avoid breaking down of the vehicle, but also avoid the situation that it is impossible to perform balancing of the battery in time after the breaking down of the vehicle, thus improving the use experience of the vehicle.

In some embodiments, after said performing negative pulse discharging on a battery, the method further comprises: resting the battery for which the discharging is completed for a second preset duration. In this embodiment, by resting the discharged battery, the battery can be made to depolarize to the open circuit voltage, so as to avoid influence of the polarization phenomenon of the battery after discharging on the detection of the balancing degree of the battery, thereby improving the accuracy of the battery balancing detection.

In some embodiments, said determining an unbalancing degree of the battery based on electrical parameters of battery cells in the battery after discharging comprises:
determining SOC values of the battery cells separately based on voltage values of the battery cells in the battery after discharging; and
determining the unbalancing degree of the battery according to the SOC values of the battery cells.

In this embodiment, by the way of acquiring SOC values of battery cells based on voltage values of batteries in the battery and determining the unbalancing degree of the battery based on the SOC values, it is possible to avoid detection errors brought about by DCR during the detection of the unbalancing degree in the case where a current exists when the power battery system is providing electric energy, thereby improving the accuracy of detection of the balancing degree of the battery.

In some embodiments, said determining SOC values of the battery cells separately based on voltage values of the battery cells in the battery after discharging comprises:
determining a current temperature of the battery; and acquiring current SOC values of the battery cells separately from a preset mapping relationship of battery temperatures, SOCs and voltages based on the current temperature and the voltage values of the battery cells.

In this embodiment, by the way of acquiring SOC values of the battery cells from the mapping relationship between the battery temperatures, SOCs and voltages and determining the unbalancing degree of the battery according to the SOC values, the current SOC value of each of the battery cells of the battery can be accurately acquired, so that the battery can be conveniently detected for the balancing degree by such a way at any temperature, which is applicable to a wide range of application scenarios, with few limitations, and with a high degree of accuracy.

In some embodiments, after said determining the unbalancing degree of the battery, the method further comprises: performing, if the unbalancing degree of the battery is greater than a preset threshold, a balancing operation on the battery using a preset active balancing module or passive balancing module.

In this embodiment, balancing is enabled based on the result of detection of the unbalancing degree, which enables greater utilization of the capacity of the battery of the electrical device, thereby increasing the utilization of the battery capacity and energy, increasing the battery input and output power level, and increasing the service life of the battery.

In some embodiments, before said in response to a battery balancing detection instruction, the method further comprises:
triggering the battery balancing detection instruction when the battery is detected to satisfy a first preset abnormality condition, wherein the first preset abnormality condition comprises the battery experiencing a battery cell diving phenomenon or the battery having not undergone a battery balancing detection for more than a third preset duration.

In this embodiment, the battery balancing detection instruction is triggered once the control module monitors that the battery satisfies the first preset abnormality condition, so that the battery balancing detection process can be automatically initiated when some abnormal condition occurs in the electrical device or the battery, so as to improve the degree of automation of the maintenance of the device. Timely battery balancing detection in the event of an abnormal situation in the electrical device or battery can improve the accuracy of the computation process, such as the estimation of the state of charge of the battery, the estimation of the power, and the determination of the charging rate, and reduce the situations in which the battery or the electrical device is malfunctioning due to SOC unbalancing between the battery cells in the battery. Specifically, for example, the battery balancing detection instruction is triggered upon detecting the occurrence of the battery cell diving phenomenon, and this can timely detect and calibrate the balancing degree of the battery at the time of the occurrence of the battery cell diving phenomenon, which can help to diagnose the cause of battery cell diving based on the balanced battery and control the battery more accurately. In addition, if it is detected that the battery has not undergone detection of the balancing degree for a long period of time, it indicates that the battery balancing degree currently recorded in the control module is likely to be inconsistent with the current actual situation of the battery, and at this time, the battery balancing detection instruction is triggered, which is capable of calibrating the battery balancing degree recorded in the control module, thus improving the accuracy of the recorded battery balancing degree, and thus improving the accuracy of the control of the battery based on the battery balancing degree.

In some embodiments, before said in response to a battery balancing detection instruction, the method further comprises:
receiving the battery balancing detection instruction sent by a user; or
receiving the battery balancing detection instruction that is sent by a server when it detects that a second preset abnormality condition is satisfied, wherein the second preset abnormality condition comprises the battery experiencing a battery cell diving phenomenon, or a deviation between unbalancing degrees detected by the server and by a device in which the battery is located exceeding a preset value.

In this embodiment, the user can send a battery balancing degree detection instruction through the user terminal when a detection of the battery balancing degree is required, or submit a battery balancing degree detection instruction by operation directly on the electric device, which can satisfy the need of the user for detecting the battery balancing degree in any scenario, and improve the convenience for the user in triggering the detection of the battery balancing degree; and makes it easy for the user to timely keep track of the balancing degree of the battery and balance the battery. At the same time, it is possible to calibrate the battery balancing degree recorded in the control module to improve the accuracy of the recorded battery balancing degree, thereby improving the accuracy of the control of the battery based on the battery balancing degree. Alternatively, the server issues a battery balancing detection instruction when it monitors that the deviation between the battery unbalancing degrees exceeds a preset value, so that the server end triggers the detection of the balancing degree of the battery when it detects an abnormality of the electrical device or the battery, thereby improving the degree of automation of the maintenance of the device. Timely battery balancing detection in the event of abnormal situations can reduce the number of cases in which the battery or electrical device is malfunctioning due to a too large battery unbalancing degree. Moreover, this helps to keep the balancing degrees of the battery recorded by the electrical device and the server consistent, and improves the accuracy of the control over the electrical device by the server side based on the balancing degrees of the battery, and improves the accuracy of the data analysis by the server side based on the balancing degrees of the battery.

In some embodiments, it is determined that an electrical device in which the battery is located is connected to a charging and discharging device. In this embodiment, by determining that the electrical device where the battery is located is connected to the charging and discharging device, it is possible to judge whether the charging and discharging device is malfunctioning or is not connected to the electrical device, and it is possible to automatically or actively calibrate the unbalancing degree of the battery pack in the vehicle to improve the level of automation of the detection of the battery balancing degree, thereby enabling greater utilization of the capacity of battery cells in the battery pack, thus improving the use experience of the vehicle.

In a second aspect, embodiments of the present invention provide a battery balancing detection apparatus, comprising:
a discharging unit for performing negative pulse discharging on a battery in response to a battery balancing detection instruction; and
a determination unit for determining an unbalancing degree of the battery based on electrical parameters of battery cells in the battery after discharging.

In a third aspect, embodiments of the present invention provide an electronic device, comprising a memory, a processor, and a computer program stored in the memory and runnable on the processor, wherein the processor, when executing the computer program, implements the method as described in the first aspect.

In a fourth aspect, embodiments of the present invention provide a computer-readable storage medium having a computer program stored therein, wherein the computer program, when executed by a processor, implements the method as described in the first aspect.

The above description is only a summary of the technical solutions of the present application. In order to be able to understand the technical means of the present application more clearly, the technical means can be implemented according to the content of the specification. Furthermore, to make the above and other objectives, features and advantages of the present application more comprehensible, specific implementations of the present application are exemplified below.

### Description of Drawings

Various other advantages and benefits will become apparent to those of ordinary skill in the art upon reading the following detailed description of the preferred implementations. The drawings are for the purpose of illustrating the preferred implementations only and are not to be considered a limitation to the present application. Moreover, in all of the accompanying drawings, the same parts are indicated by the same reference numerals. In the drawings:
Fig. 1 is a flowchart of a battery balancing detection method provided in an embodiment of the present invention;
Fig. 2 is a schematic diagram of an SOC-OCV curve of a battery cell-with-platform provided in an embodiment of the present invention;
Fig. 3 is a schematic diagram of an SOC-OCV curve of a battery cell-without-platform provided in an embodiment of the present invention;
Fig. 4 is another flowchart of a battery balancing detection method provided in an embodiment of the present invention;
Fig. 5 is a structural schematic diagram of a battery balancing detection apparatus provided in an embodiment of the present invention; and
Fig. 6 is a structural schematic diagram of an electronic device provided in an embodiment of the present invention.

### Detailed Description

Embodiments of the technical solutions of the present application will be described in detail below in conjunction with the drawings. The following embodiments are only used to more clearly illustrate the technical solution of the present application, and therefore are only used as examples and cannot be used to limit the scope of protection of the present application.

Unless otherwise defined, all technical and scientific terms used herein have the same meaning as commonly understood by those skilled in the art belonging to the technical field of the present application; the terms used herein are intended only for the purpose of describing specific embodiments and are not intended to limit the present application; the terms "comprise/include" and "have" and any variations thereof in the specification and the claims of the present application and in the description of drawings above are intended to cover non-exclusive inclusion.

In the description of embodiments of the present invention, the technical terms "first", "second", and the like are used only to distinguish between different objects, and are not to be understood as indicating or implying a relative importance or implicitly specifying the number, particular order, or primary and secondary relation of the technical features indicated. In the description of the embodiments of the present invention, the meaning of "a plurality of' is two or more, unless otherwise explicitly and specifically defined.

Reference herein to "an embodiment" means that a particular feature, structure, or characteristic described in connection with the embodiment can be included in at least one embodiment of the present application. The appearance of this phrase in various places in the specification does not necessarily refer to the same embodiment, nor is it a separate or alternative embodiment that is mutually exclusive with other embodiments. It is explicitly and implicitly understood by those skilled in the art that the embodiments described herein may be combined with other embodiments.

In the description of the embodiments of the present invention, the term "and/or" is only an association relationship for describing associated objects, indicating that there may be three relationships, for example A and/or B may represent three situations: A exists alone, both A and B exist, and B exists alone. In addition, the character "/" herein generally means that the associated objects before and after it are in an "or" relationship.

In the description of the embodiments of the present invention, the term "a plurality of' refers to two or more (including two), and similarly, "multiple groups" refers to two or more (including two) groups, and "multiple sheets" refers to two or more (including two) sheets.

In the description of the embodiments of the present invention, the orientation or position relationship indicated by the technical terms "center", "longitudinal", "transverse", "length", "width", "thickness", "upper," "lower," "front," "back," "left," "right," "vertical," "horizontal," "top," "bottom," "inner," "outer," "clockwise," "counterclockwise," "axial", "radial", "circumferential", etc., are based on the orientation or position relationship shown in the drawings and are intended to facilitate the description of the embodiments of the present invention and simplify the description only, rather than indicating or implying that the device or element referred to must have a particular orientation or be constructed and operated in a particular orientation, and therefore are not to be interpreted as limitations on the embodiments of the present invention.

In the description of the embodiments of the present invention, unless otherwise expressly specified and limited, the technical terms "mount," "join," "connect," "fix," etc. should be understood in a broad sense, such as, a fixed connection, a detachable connection, or an integral connection; a mechanical connection, or an electrical connection; a direct connection, an indirect connection through an intermediate medium, an internal connection of two elements, or interaction between two elements. For those of ordinary skill in the art, the specific meanings of the above terms in the embodiments of the present invention can be understood according to specific situations.

At present, from the perspective of the development of the market situation, power batteries are more and more widely used. The power batteries are used in energy storage power source systems such as hydraulic, thermal, wind and solar power stations as well as in electric vehicles such as electric bicycles, electric motorcycles and electric cars, and military equipment and aerospace fields. In electric transportation supplies, military equipment, aerospace, and other fields, power is usually provided through batteries.

The inconsistency (balancing degree) of a battery is one of the important parameters of the battery. The unbalance of cell batteries may lead to a phenomenon that a certain battery cell is overcharged earlier than others during the charging stage of the battery, and a phenomenon that a certain battery cell is overdischarged earlier than others during the discharging stage. Therefore, the balancing degree of the battery plays an important role in both efficiency and safety of use. Therefore, it is often necessary to detect the balancing degree of the battery during the use of the battery by the electrical device. In the related art, when the unbalancing degree of the battery is detected to reach a certain threshold, in order to improve the consistency of the battery during use, it is necessary to carry out a balancing operation of the battery based on the direct unbalancing degree of the battery cells.

The inventor of the present application found, in the course of researching the battery balancing detection approach, that in the case where current exists when the power battery system is providing electric energy, the voltage difference may be due to the difference in the direct current resistance (DCR), and not only due to the difference in the SOC between the battery cells; therefore, identifying the unbalancing degree of the battery by judging the voltage difference of the power battery system leads to a lower accuracy in detecting the battery unbalancing degree, and the scope of application of the above detection approach is small.

In order to provide a battery balancing detection method that is applicable to various operating conditions and different types of batteries under different aging paths. The inventors of the present application have designed, after thorough research, a battery balancing detection method comprising: performing negative pulse discharging on a battery in response to a battery balancing detection instruction; and determining an unbalancing degree of the battery based on electrical parameters of battery cells in the battery after discharging.

This method designs different target detection operating conditions for battery balancing detection instructions in different application scenarios. Upon receiving a battery balancing detection instruction triggered in a certain application scenario, negative pulse discharging is first performed on the battery, and then the unbalancing degree of the battery is determined based on the electrical parameters of battery cells in the battery after the discharging, which can avoid detection errors brought about by DCR when detecting the unbalancing degree in the case where current exists when the power battery system is providing electric energy, thereby improving the accuracy of the detection of the battery unbalancing degree, and can also take into account the detection of the unbalancing degree of the battery while detecting the SOH of the battery through negative pulses, thus meeting the demand for detecting the unbalancing degree of the battery in various operating conditions, thereby enabling greater utilization of the capacity of battery cells in the battery pack, thus improving the use experience of the vehicle. The method is not only applicable to energy storage systems, but also to vehicle-end, server-end, or user-end detection requests. This detection method has low limitations and has a high general applicability.

The battery balancing detection method provided in embodiments of the present invention may be applied to any battery, which may be a battery cell, or a battery group or battery pack consisting of a plurality of battery cells, or the like. The electrical device to which the method provided in embodiments of the present invention may be applied may be, but is not limited to, an electric toy, a power tool, a battery operated vehicle, an electric car, a ship, a spacecraft, or the like, that is provided with a battery. Among them, the electric toy may include a stationary or mobile electric toy, for example, a game console, an electric car toy, an electric ship toy, and an electric aircraft toy, and the like, and the spacecraft may include an aircraft, a rocket, a space shuttle and a spaceship, and the like.

The above electrical device may be communicatively connected to a server, which may be a single physical server device, a cluster of servers consisting of a plurality of devices, or a cloud server in a public cloud, a private cloud, or the like. The electrical device may receive a battery balancing detection instruction sent by the server and detect a balancing degree of the battery by the method of the embodiments of the present invention. The above electrical device may also be communicatively connected to a user terminal such as a cell phone, a tablet computer, a laptop computer, etc., of the user, and the electrical device may receive a battery balancing detection instruction that is sent by the user through the user terminal and detect a balancing degree of the battery by the method of embodiments of the present invention. Alternatively, the control module in the electrical device may also provide the user with an interface for triggering the battery balancing detection instruction, through which the user may submit the battery balancing detection instruction to the electrical device. For example, a button to initiate battery balancing detection may be displayed on a center console of the electric vehicle, and the user may click the button to submit a battery balancing detection instruction to the electric vehicle. The electrical device may also be connected to a charging and discharging device within a location such as a charging station or a battery swapping station to receive a battery balancing detection instruction triggered by the charging and discharging device. This charging and discharging device can be a charging pile, a charging and discharging machine, and the like. The above electrical device may also be connected to a maintenance device to receive a battery balancing detection instruction triggered by the maintenance device.

The above lists a variety of application scenarios in which the electrical device is connected to other devices and receives battery balancing detection instructions triggered by these other devices, but the present application is not limited to the application scenarios listed above, and for any other application scenarios in which battery balancing detections can be triggered, the unbalancing degree of the battery can be detected in accordance with the method provided in embodiments of the present invention, including the battery balancing detection that is triggered actively by the control module of the electrical device itself based on the state of the electrical device and/or the battery.

The specific process of detecting the battery balancing degree of the present application is described in detail below by way of specific embodiments. Embodiments of the present invention provide a battery balancing detection method, which performs negative pulse discharging on a battery, and determines the unbalancing degree of the battery based on the electrical parameters of battery cells in the battery after the discharging, which can avoid detection errors brought about by DCR when detecting the unbalancing degree in the case where current exists when the power battery system is providing electric energy, and can also take into account the detection of the unbalancing degree of the battery while detecting the SOH of the battery through negative pulses, thus meeting the demand for detecting the unbalancing degree of the battery in various operating conditions. The method is not only applicable to energy storage systems, but also to vehicle-end, server-end, or user-end detection requests. This detection method has low limitations and has a high general applicability.

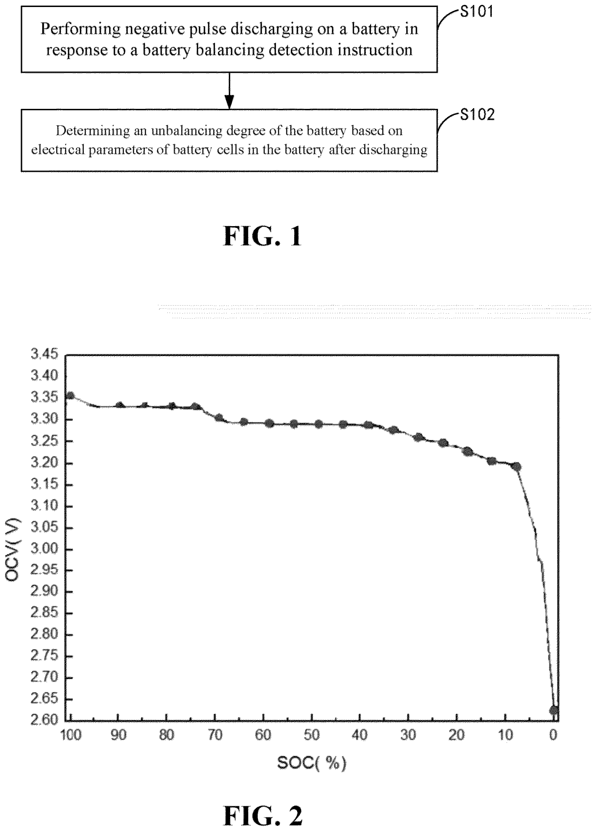

Referring to the flowchart of the battery balancing detection method shown in Fig. 1, the method specifically includes the following steps:
Step S101: performing negative pulse discharging on a battery in response to a battery balancing detection instruction.

The execution subject in embodiments of the present invention is an electrical device or a control module in an electrical device, or the like. This control module can be a BMS (Battery Management System), a VCU (Vehicle Control Unit), a DC (Domain Controller), and so on. Embodiments of the present invention are described in detail taking an example in which the execution subject is a control module.

The battery balancing detection method of embodiments of the present invention can be applied in various application scenarios where the battery balancing degree needs to be detected. Embodiments of the present invention divide various application scenarios into three categories, namely, electrical device end, user end, and server end, in accordance with different sources of the detection instructions. This division is only an example, and there may be other divisions in practical applications, and there may be application scenarios from sources other than the three ends, which will not be enumerated herein.

For a detection instruction originating from the electrical device end where the battery is located, it may be monitored in real time by the control module of the electrical device, and a battery balancing detection instruction is triggered when the battery is monitored to satisfy a first preset abnormality condition, wherein the first preset abnormality condition comprises the battery experiencing a battery cell diving phenomenon or the battery having not undergone a battery balancing detection for more than a third preset duration. The preset duration can be 5 months, half a year or a year, and so on.

For example, if the BMS monitors that a battery cell of the battery experiences a sharp drop in power within a short period of time, it confirms that there is a battery cell diving phenomenon, and at this time, the BMS triggers a battery balancing detection instruction. As another example, the BMS is pre-configured with a preset calculation condition that is required to be satisfied by the battery for triggering battery balancing detection, wherein the preset calculation condition may include a certain state of charge (SOC), a specific battery temperature, or the like, and if the BMS monitors that the battery has not reached the preset calculation condition for a preset duration, it will trigger a battery balancing detection instruction.

The first preset abnormality condition may also include any other situation in which the battery balancing detection instruction is triggered actively by the electric device itself. For example, if the VCU monitors that the electric vehicle is experiencing range degradation, it triggers a battery balancing detection instruction, or the like, which will not be enumerated herein in the embodiments of the present invention.

The battery balancing detection instruction is triggered once the control module monitors that the battery satisfies the first preset abnormality condition as described above, so that the battery balancing detection process can be automatically initiated when some abnormal condition occurs in the electrical device or the battery, so as to improve the degree of automation of the maintenance of the device. Timely battery balancing detection in the event of an abnormal situation in the electrical device or battery can improve the accuracy of the computation process, such as the estimation of the state of charge of the battery, the estimation of the power, and the determination of the charging rate, based on the battery balancing degree, and reduce the situations in which the battery or the electrical device is malfunctioning due to inaccuracy of the battery balancing degree. Specifically, for example, the battery balancing detection instruction is triggered upon detecting the occurrence of the battery cell diving phenomenon, and this can timely detect and balance the battery at the time of the occurrence of the battery cell diving phenomenon, thereby reducing the inconsistency between the battery cells, which can help to diagnose the cause of the battery cell diving based on the calibrated battery balancing degree and control the battery more accurately based on the battery balancing degree. As another example, if it is detected that the battery has not undergone detection of the battery balancing degree for a long period of time, it indicates that the battery balancing degree currently recorded in the control module is very likely to be inconsistent with the current actual situation of the battery, and at this time, the battery balancing degree detection instruction is triggered to monitor the balancing degree of the battery and balance the battery, thus improving the accuracy of the control of the battery based on the battery balancing degree. In addition, it is also possible to improve the consistency of the battery cells within the battery during use, thus improving the utilization of battery energy and its service life.

In the case where the battery balancing detection instruction originates from the user end, for example, when the user finds that the electrical device fails to accurately display the balancing degree of the battery, or when the user has not used the electrical device for a long period of time, which results in a prolonged power outage of the BMS, or for an electric vehicle, the user finds that the electric vehicle suffers from a range degradation, or when the user needs to buy or sell a second-hand electric vehicle, it is necessary to evaluate the balancing degree of the battery. The situations where the battery balancing detection instruction originates from the user end are not limited to those listed here, but any other situation triggered by the user applies.

The user terminal, such as a cell phone or a computer, of the user may be installed with an application associated with the electrical device, which is provided with an interface for triggering the battery balancing detection instruction. In any case where the user needs to detect the battery balancing degree, the user triggers the battery balancing degree detection instruction through an interface provided by the application on the user terminal, and the user terminal sends the battery balancing detection instruction to the electrical device.

Alternatively, the electrical device is provided with a mechanical button for triggering the battery balancing detection, or an interface displayed on the display screen of the electrical device is provided with a button for triggering the battery balancing detection. In any situation where the user needs to detect the battery balancing degree, the user triggers the battery balancing detection by operating these buttons and when the electric device detects the operation events of these buttons, it determines that the battery balancing detection instruction submitted by the user is received.

The above user can send a battery balancing detection instruction through the user terminal when a battery balancing detection is required, or submit a battery detection instruction by operation directly on the electric device, which can satisfy the need of the user for detecting the battery balancing degree in any scenario, and improve the convenience for the user in triggering the detection of the battery balancing degree. Timely detection and balancing of the battery when required by the user makes it easy for the user to keep track of the actual balancing degree of the battery, and helps to improve the energy utilization and service life of the battery. At the same time, it is possible to timely calibrate the balancing degree of the battery recorded in the control module to improve the accuracy of the recorded balancing degree of the battery, thereby improving the accuracy of the control of the battery based on the balancing degree of the battery.

For the case where the battery balancing detection instruction originates from the server end, the battery balancing detection instruction is sent to the electrical device when the server detects that a second preset abnormality condition is satisfied. The electrical device receives the battery balancing detection instruction that is sent by the server. Here, the second preset abnormality condition comprises the battery experiencing a battery cell diving phenomenon, or a deviation between unbalancing degrees detected by the server and by the electrical device in which the battery is located exceeding a preset threshold, or the SOC of part of the battery cells of the battery under a certain operating condition experiencing an outlier phenomenon, and the like.

In embodiments of the present invention, for batteries of the same model type applied to the same type of electrical devices, the server counts the SOC values of these batteries under various operating conditions. Under the same operating condition, the SOC values of these batteries will be concentrated in an interval that spans a small range. If the server detects that the SOC value of the battery of the electrical device under a certain operating condition is not within the SOC interval of the same type of batteries under that operating condition, the server determines that the SOC of the battery under that operating condition is experiencing an outlier phenomenon.

The second preset abnormality condition may also include any other situations in which the server issues the battery balancing detection instruction, for example, the server issues the battery balancing detection instruction when it monitors that the electric vehicle is experiencing a range degradation, and so on, which will not be enumerated herein by embodiments of the present invention.

The server issues a battery balancing detection instruction when it monitors that the second preset abnormality condition is satisfied, so that the server end triggers the detection of the balancing degree of the battery when it detects an abnormality of the electrical device or the battery, thereby improving the degree of automation of the maintenance of the device. Timely battery balancing detection in the event of abnormal situations can reduce the number of cases in which the battery or electrical device is malfunctioning due to a too large battery unbalancing degree. Moreover, this helps to keep the balancing degrees of the battery recorded by the electrical device and the server consistent, and improves the accuracy of the control over the electrical device by the server side based on the balancing degrees of the battery, and improves the accuracy of the data analysis by the server side based on the balancing degrees of the battery.

For the battery balancing detection instruction triggered by the above electric device end, server end and user end, etc., in any scenario, the control module of the electrical device initiates detection of the current balancing degree of the battery in response to the battery balancing detection instruction. In embodiments of the present invention, the operating condition refers to an operating state of the battery, and the operating condition parameters include parameters such as the battery temperature, current, voltage, SOC, and the like when the battery is operating in that detection operating condition.

In embodiments of the present invention, before carrying out balancing detection of the battery, first, the control module determines whether the current electrical device is connected to the charging and discharging device, wherein both the charging and discharging device and the electrical device support the negative pulse function, and by determining that the electrical device in which the battery is located is connected to the charging and discharging device, it is possible to judge whether the charging and discharging device is malfunctioning or is not connected to the electrical device, and when the charging and discharging device malfunctions, in the interface displayed on the display screen of the electrical device, the cause of the malfunction can be displayed, and the electrical device not being connected to the charging and discharging device can be displayed, which allows for timely alerts to overhaul the charging and discharging device and to replace the charging and discharging device; in addition, when the control module determines that the current electrical device is connected to the charging and discharging device, it can automatically or actively calibrate the unbalancing degree of the battery pack in the vehicle, which not only improves the automation level of the detection of the battery balancing degree, but also enables greater utilization of the capacity of the battery cells in the battery pack, thus improving the use experience of the vehicle.

Optionally, in one or more embodiments, said performing negative pulse discharging on a battery comprises: performing negative pulse discharging of the battery to discharge the battery from a current state of charge (SOC) to a target SOC. Specifically, the target SOC here is determined based on different types of batteries, and the detection of the balancing degree of different types of batteries can be performed quickly and flexibly by discharging the current SOC of the battery to a preset target SOC by means of negative pulses. This detection method has low limitations and has a high general applicability.

Specifically, when the above battery is a battery-with-platform, said performing negative pulse discharging of the battery to discharge the battery from a current state of charge (SOC) to a target SOC comprises: determining as the target SOC any SOC that is less than the current SOC of the battery within an SOC interval of the curve that has a non-zero slope; and reducing an SOC of the battery to the target SOC based on negative pulses.

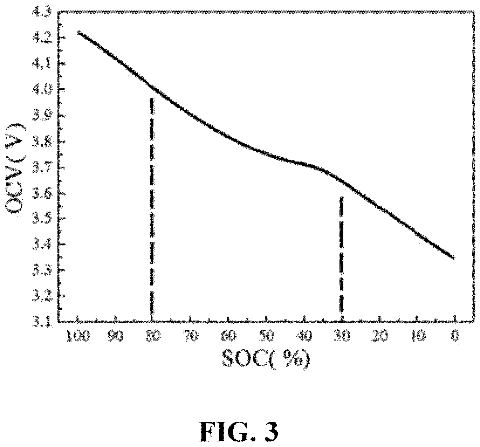

As shown in Fig. 3, the slope of the SOC-open circuit voltage (OCV) curve corresponding to a battery-with-platform contains intervals with zero slopes (75% SOC-95% SOC, and 40% SOC-65% SOC), such as a lithium-iron phosphorus battery (LFP) battery, and during discharging of this type of battery, assuming that the current SOC of the battery is 70% SOC, any SOC that is less than 70% SOC within the SOC interval of the SOC-OCV curve that has a non-zero slope is determined to be the target SOC, for example, the target SOC is 35% SOC, and then the battery is reduced from 70% SOC to said 35% SOC based on negative pulses.

In the related art, the method of identifying a battery unbalancing degree has significant limitations on the operating conditions. For example, battery cells that have platform zones must be discharged to the low end (below 25% SOC) in order to accurately identify ΔSOC (the unbalancing degree) among the battery cells. In this embodiment, when performing a detection of the balancing degree of a battery-without-platform, it is only necessary to discharge the SOC of this type of battery to an SOC interval corresponding to the operating condition of the electrical device, without the need of discharging this type of battery to the low end, thus making it possible to avoid the phenomenon of the vehicle breaking down, thereby enhancing the safety of the usage process of the battery.

Optionally, in an embodiment, when the above battery is a battery-without-platform, said performing negative pulse discharging of the battery to discharge the battery from a current state of charge (SOC) to a target SOC comprises: selecting as the target SOC any SOC that is less than the current SOC of the battery from an SOC interval constituted by a maximum SOC and a minimum SOC of an operating condition of an electrical device during a first preset duration; and reducing an SOC of the battery to the target SOC based on negative pulses.

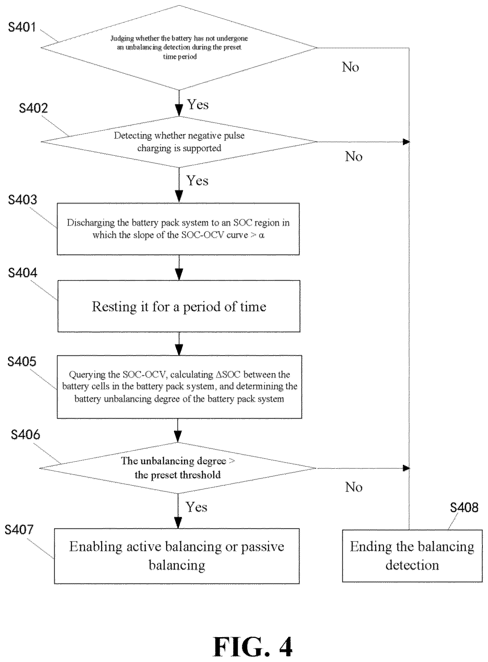

Specifically, as shown in Fig. 4, the slope of the SOC-OCV curve corresponding to the battery-without-platform does not include an interval with a slope of zero, such as a lithium nickel cobalt manganese oxide (NCM) battery, and in the process of discharging this type of battery, assuming that the current SOC of the battery is 70% SOC, then from an SOC interval constituted by a maximum SOC and a minimum SOC of the operating condition of the electrical device within one month (e.g., the interval 30% SOC-80% SOC within the dotted line in Fig. 4), any SOC that is less than the current SOC of the battery is selected as the target SOC, for example, the target SOC is 50% SOC, and then the battery is reduced from 70% SOC to said 50% SOC based on negative pulses.

In this embodiment, when detecting the balancing degree of a battery-without-platform, the balancing degree can be detected by discharging the SOC of the battery of this type to the SOC interval corresponding to the operating condition of the electrical device without discharging the battery of this type to the low end, which can not only avoid breaking down of the vehicle, but also avoid the situation that it is impossible to perform balancing of the battery in time after the breaking down of the vehicle, thus improving the use experience of the vehicle.

Optionally, in one or more embodiments, in the above battery balancing detection method, after said performing negative pulse discharging on a battery, the method further comprises: resting the battery for which the discharging is completed for a second preset duration.

In the related art, after discharging the battery, the battery will experience a polarization phenomenon, that is, the SOC of the battery cells in the battery will float, which will have a certain impact on the battery balancing detection. Therefore, in order to avoid the impact brought about by the polarization of the battery, the battery for which the discharging is completed is rested for a period of time, so that the power of each battery cell in the battery reaches a stable state. It is noted that the second preset duration herein may be obtained based on multiple measurements of the time for the battery cell to depolarize to the open circuit voltage.

In embodiments of the present invention, by resting the discharged battery, the battery can be made to depolarize to the open circuit voltage, so as to avoid influence of the polarization phenomenon of the battery after discharging on the detection of the balancing degree of the battery, thereby improving the accuracy of the battery balancing detection.

Step S 102: determining an unbalancing degree of the battery based on electrical parameters of battery cells in the battery after discharging.

In embodiments of the present invention, the above battery cell parameters include the current, the voltage, the current SOC and the current battery temperature of the battery, and after the battery is discharged at a preset requested negative pulse current, the unbalancing degree of the battery is determined by acquiring the electrical parameters such as the current, the voltage, the current SOC and the current battery temperature of the battery.

Specifically, for example, a current SOC value of each battery cell in the battery is acquired based on a mapping relationship between the voltages and the SOCs of battery cells, and then an unbalancing degree of the battery is determined based on the current SOC value of each battery cell. Alternatively, a current SOC value of each battery cell in the battery is acquired based on a mapping relationship between the voltages and the SOCs of battery cells and the battery temperature, and then an unbalancing degree of the battery is determined based on the current SOC value of each battery cell. For example, the current battery includes 4 battery cells A, B and C, where the SOC of battery cell A is 40% SOC, the SOC of battery cell A is 30% SOC, and the SOC of battery cell A is 60% SOC, then the unbalancing degree of the current battery can be obtained by the algorithm of averaging the direct SOC differences of the three, and finally the variance degree ΔSOC of the battery can be obtained as 20% SOC.

Optionally, in one or more embodiments, said determining an unbalancing degree of the battery based on electrical parameters of battery cells in the battery after discharging comprises: determining SOC values of the battery cells separately based on voltage values of the battery cells in the battery after discharging; and determining the unbalancing degree of the battery according to the SOC values of the battery cells. In embodiments of the present invention, with the technical means of determining SOC values of the battery cells separately based on voltage values of the battery cells in the battery after discharging and determining the unbalancing degree of the battery according to the SOC values of the battery cells, it is possible to avoid detection errors brought about by DCR during the detection of the unbalancing degree in the case where a current exists when the power battery system is providing electric energy, thereby improving the accuracy of detection of the balancing degree of the battery.

Optionally, in one or more embodiments, said determining SOC values of the battery cells separately based on voltage values of the battery cells in the battery after discharging comprises:
determining a current temperature of the battery; and acquiring current SOC values of the battery cells separately from a preset mapping relationship of battery temperatures, SOCs and voltages based on the current temperature and the voltage values of the battery cells.

In embodiments of the present invention, a preset SOC query set is pre-set, which stores an SOC-battery temperature-battery cell voltage mapping relationship. When the discharged battery is rested to the open circuit voltage, an SOC associated with both the first preset temperature and voltage is queried from a preset SOC query set. In this way, it is possible to accurately acquire the SOC value of each battery cell in the current battery, so that such an approach can be conveniently and quickly adopted for detecting the balancing degree of the battery at any temperature, and thus is applicable to a wide range of application scenarios, with fast detection speed and high accuracy.

As an example, the SOC query set may be a data set in the form of a table. For example, as shown in Table 1 below:

**Table 1**

| SOC query table (20°C) | | | | | |
|---|---|---|---|---|---|
| | SOC1 | SOC2 | SOC3 | SOC4 | ... |
| Voltage value 1 | f11 | f21 | f31 | f41 | ... |
| Voltage value 2 | f12 | f22 | f32 | f42 | ... |
| Voltage value 3 | f13 | f23 | f33 | f43 | ... |
| Voltage value 4 | f14 | f24 | f34 | f44 | ... |
| Voltage value 5 | f15 | f25 | f35 | f45 | ... |
| ⋮ | ⋮ | ⋮ | ⋮ | ⋮ | ... |

As another example, the SOC query set may also be a data set in the form of a formula. That is, the SOC data set records a formula for each SOC with corresponding temperature and voltage values, so that after the BMS obtains the current battery temperature and a certain voltage value, it calculates the corresponding SOC value using the corresponding calculation formula.

Optionally, in one or more embodiments, after said determining the unbalancing degree of the battery, the method further comprises: performing, if the unbalancing degree of the battery is greater than a preset threshold, a balancing operation on the battery using a preset active balancing module or passive balancing module.

Specifically, the preset threshold herein may be obtained based on the operating conditions of the battery in use. For example, when the electrical device has serious power degradation during use, the battery has a high unbalancing degree, which means that there is a large SOC difference between the battery cells within the battery, and thus the battery needs to be balanced.

The passive balancing crossing module employed in embodiments of the present invention discharges battery cells of higher voltages by means of discharging them through resistors, thereby releasing power in the form of heat. By discharging cell batteries (e.g., battery cells) of relatively high voltages through resistors, they are kept in an equal or nearly equal state of charge with cell batteries of low voltages. This is because the energy in a highly charged battery is dissipated by heat. The active balancing module transfers the energy from the cell batteries with higher voltages in the battery module to the cell batteries with lower voltages, thus realizing the redistribution of battery energy so as to achieve inter-battery balancing.

In embodiments of the present invention, by way of enabling balancing on the basis of the result of the detection of the unbalancing degree of the battery, it is possible to enable greater utilization of the battery capacity of the electrical device, thereby increasing the utilization of the battery capacity and energy, increasing the battery input and output power level, and increasing the safety and the service life of the battery.

Specific illustrations are given below taking as an example the way of detecting the battery balancing degree based on the SOC of the battery under the operating condition of charging and discharging of an electric vehicle. When the electric vehicle is located in a battery swapping station or charging station, the electric vehicle establishes a connection with the charging and discharging machine in the station and the host computer in the station:
Step S401: judging whether the battery has not undergone an unbalancing detection during the preset time period, if so, proceeding to step S402, or if not, proceeding to step S408;
Step S402: detecting whether the current vehicle supports negative pulse charging, if so, proceeding to step S403, or if not, proceeding to step S408;
Step S403: discharging the battery pack system of the current vehicle to an SOC region in which the slope of the SOC-OCV curve is greater than a preset value, where the preset value is any value greater than zero; if the battery cells in the current battery pack system are battery cells-with-platform, such as lithium iron phosphate (LFP) battery cells, discharging the battery pack system to an arbitrary value of less than 25% SOC; and if the battery cells in the current battery pack system are battery cells-without-platform, such as lithium nickel cobalt manganese oxide (NCM) battery cells, it is necessary to discharge the battery pack system to any SOC value that is lower than the current SOC value within the vehicle driving operating condition according to the maximum/minimum SOC of the vehicle driving operating condition.
Step S404: resting the battery pack system discharged in step S403 for a preset duration, where the preset duration is determined according to a time of depolarization of battery cells in the battery pack system to an open-circuit voltage.
Step S405: querying the SOC-OCV correspondence from the BMS of the current vehicle, acquiring the SOC of each battery cell according to the current voltage of each battery cell, and calculating the direct difference ΔSOC of the battery cells, and calculating the unbalancing degree of the battery pack system according to the ΔSOC.
Step S406: according to the balancing degree determined in step S405, judging whether it is greater than a preset threshold, and when the unbalancing is greater than the preset threshold, proceeding to step S407, otherwise, executing step S408.
Step S407: performing active balancing or passive balancing of the battery pack system.
Step S408: ending the battery balancing detection operation.

With the technical solution of the present application, negative pulse discharging is performed on a battery, and the unbalancing degree of the battery is determined based on the electrical parameters of battery cells in the battery after the discharging, which can avoid detection errors brought about by DCR when detecting the unbalancing degree in the case where current exists when the power battery system is providing electric energy, and can also take into account the detection of the unbalancing degree of the battery while detecting the state of health (SOH) of the battery through negative pulses, thus meeting the demand for detecting the unbalancing degree of the battery in various operating conditions. This method can automatically or actively calibrate the unbalancing degree of the battery pack within the vehicle, thereby enabling greater utilization of the capacity of the battery cells within the battery pack, thus improving the use experience of the vehicle.

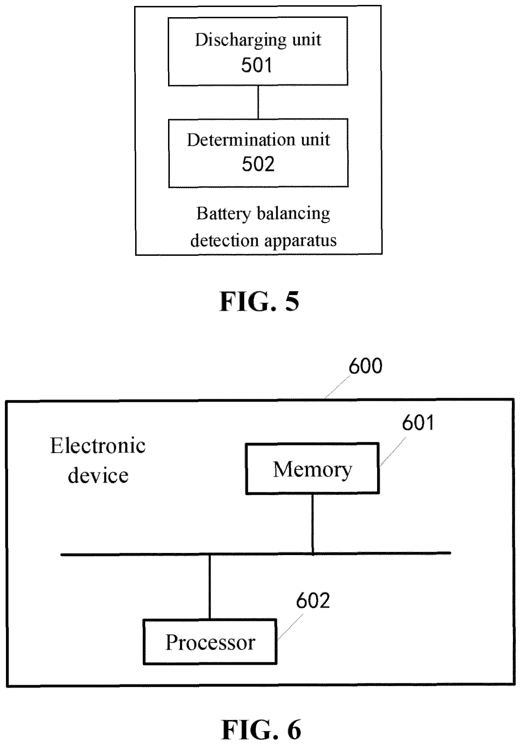

Embodiments of the present invention further provide a battery balancing detection apparatus. The apparatus is used to perform the battery balancing detection method provided in the above embodiments, as shown in Fig. 5, the apparatus comprising:
a discharging unit 501 for performing negative pulse discharging on a battery in response to a battery balancing detection instruction; and
a determination unit 502 for determining an unbalancing degree of the battery based on electrical parameters of battery cells in the battery after discharging.

In the technical solution of embodiments of the present invention, by performing negative pulse discharging on a battery, and determining the unbalancing degree of the battery based on the electrical parameters of battery cells in the battery after the discharging, it is possible to avoid detection errors brought about by DCR when detecting the unbalancing degree in the case where current exists when the power battery system is providing electric energy, thereby improving the accuracy of the detection of the unbalancing degree of the battery, and also to take into account the detection of the unbalancing degree of the battery while detecting the state of health of the battery through negative pulses, thus meeting the demand for detecting the unbalancing degree of the battery in various operating conditions. The method is not only applicable to energy storage systems, but also to vehicle-end, server-end, or user-end detection requests. This detection method has low limitations and has a high general applicability.

In another implementation of the present application, the above discharging unit 501 comprises:
a discharging module for performing negative pulse discharging of the battery to discharge the above battery from a current state of charge (SOC) to a target SOC.

In another implementation of the present application, the above battery is a battery-with-platform, the slope of an SOC-open circuit voltage (OCV) curve corresponding to the above battery-with-platform containing an interval having a zero slope; and the above discharging module comprises:
a first determination sub-unit for determining as the target SOC any SOC that is less than the current SOC of the above battery within an SOC interval of the above curve that has a non-zero slope; and
a first adjustment unit for reducing an SOC of the above battery to the above target SOC based on negative pulses.

In another implementation of the present application, the above battery is a battery-without-platform, the slope of an SOC-OCV curve corresponding to the above battery-without-platform not containing an interval having a zero slope; and the above discharging module further comprises:
a selection sub-unit for selecting as the target SOC any SOC that is less than the current SOC of the above battery from an SOC interval constituted by a maximum SOC and a minimum SOC of an operating condition of an electrical device during a first preset duration; and
a second adjustment unit for reducing an SOC of the above battery to the above target SOC based on negative pulses.

In another implementation of the present application, the above battery balancing detection apparatus further comprises:
a resting unit for resting the above battery for which the discharging is completed for a second preset duration.

In another implementation of the present application, the above determination unit 502 comprises:
a first determination module for determining SOC values of the battery cells separately based on voltage values of the battery cells in the above battery after discharging; and
a second determination module for determining the unbalancing degree of the above battery according to the SOC values of the battery cells.

In another implementation of the present application, the above first determination module comprises:
a second determination sub-unit for determining a current temperature of the battery; and
an acquisition sub-unit for acquiring current SOC values of the battery cells separately from a preset mapping relationship of battery temperatures, SOCs and voltages based on the above current temperature and the voltage values of the battery cells.

In another implementation of the present application, the above battery balancing detection apparatus further comprises:
a balancing unit for performing, if the unbalancing degree of the above battery is greater than a preset threshold, a balancing operation on the above battery using a preset active balancing module or passive balancing module.

In another implementation of the present application, the above battery balancing detection apparatus further comprises:
a first triggering unit for triggering the battery balancing detection instruction when the above battery is detected to satisfy a first preset abnormality condition, wherein the above first preset abnormality condition comprises the above battery experiencing a battery cell diving phenomenon or the above battery having not undergone a battery balancing detection for more than a third preset duration.

In another implementation of the present application, the above battery balancing detection apparatus further comprises:
a first receiving unit for receiving the battery balancing detection instruction sent by a user; or
a second receiving unit for receiving the battery balancing detection instruction that is sent by a server when it detects that a second preset abnormality condition is satisfied, wherein the above second preset abnormality condition comprises the above battery experiencing a battery cell diving phenomenon, or a deviation between unbalancing degrees detected by the above server and by a device in which the above battery is located exceeding a preset value.

In another implementation of the present application, the above battery balancing detection apparatus further comprises:
a connection determining unit for determining that an electrical device in which the above battery is located is connected to a charging and discharging device.

The battery charging apparatus provided in the above embodiments of the present application is motivated by the same inventive concept as the battery charging method provided in the embodiments of the present application, and has the same beneficial effect as the method employed, operated, or realized by the application stored therein.

Fig. 6 is a logic structural block diagram of an electronic device illustrated according to an exemplary embodiment. For example, the electronic device 600 may be an electronic device such as a BMS, an on-board controller, a motor controller, a domain controller, or the like that is provided inside the electrical apparatus.

In an exemplary embodiment, there is also provided a non-transitory computer-readable storage medium comprising instructions, such as a memory comprising instructions, the above instructions being executable by a battery processor to accomplish the above battery charging method. The method comprises: performing negative pulse discharging on a battery in response to a battery balancing detection instruction; and determining an unbalancing degree of the battery based on electrical parameters of battery cells in the battery after discharging. Optionally, the above instruction may also be executed by the processor of the battery to accomplish other steps involved in the above exemplary embodiment. For example, the non-transitory computer-readable storage medium may be a ROM, a random access memory (RAM), a CD-ROM, a magnetic tape, a floppy disk, and an optical data storage device, among others.

In exemplary embodiments, there is also provided an application/computer program product comprising one or more instructions, the one or more instructions being executable by a processor of a battery to accomplish the above battery charging method. The method comprises: performing negative pulse discharging on a battery in response to a battery balancing detection instruction; and determining an unbalancing degree of the battery based on electrical parameters of battery cells in the battery after discharging. Optionally, the above instruction may also be executed by the processor of the battery to accomplish other steps involved in the above exemplary embodiment.

Fig. 6 is an example diagram of an electronic device 600. It will be understood by those skilled in the art that the schematic diagram 6 is merely an example of the electronic device 600 and does not constitute a limitation of the electronic device 600, which may include more or fewer components than illustrated, or a combination of certain components, or different components, for example, the electronic device 600 may also include an input-output device, a network access device, a bus, and the like.

The so called processor 602 may be a central processing unit (CPU), and may also be other general purpose processors, digital signal processors (DSPs), application specific integrated circuits (ASICs), field-programmable gate arrays (FPGAs) or other programmable logic devices, discrete gates or transistor logic devices, discrete hardware components, among others. The general purpose processor may be a microprocessor or the processor 602 may be any conventional processor, etc., and the processor 602 is the control center of the electronic device 600, which utilizes a variety of interfaces and wiring to connect various portions of the entire electronic device 600.

The memory 601 may be used to store computer-readable instructions, and the processor 602 realizes various functions of the electronic device 600 by running or executing the computer-readable instructions or modules stored in the memory 601, and by calling up data stored in the memory 601. The memory 601 may mainly include a program storage area and a data storage area, wherein the program storage area may store an operating system, an application program required for at least one function (e.g., a sound playback function, an image playback function, etc.), and the like; and the data storage area may store data created in accordance with the use of the electronic device 600, and the like. In addition, the memory 601 may include a hard disk, a memory, a plug-in hard disk, a smart media card (SMC), a secure digital (SD) card, a flash card, at least one disk memory device, a flash memory device, a read-only memory (ROM), a random access memory (RAM), or other non-volatile/volatile memory devices.

The modules integrated in the electronic device 600, if implemented as a software function module and sold or used as a stand-alone product, may be stored in a computer-readable storage medium. Based on such understanding, the present invention realizes all or part of the processes in the methods of the above embodiments, which can also be accomplished by instructing relevant hardware through computer-readable instructions, wherein the computer-readable instructions can be stored in a computer-readable storage medium, and the computer-readable instructions, when executed by the central processing unit, can realize the steps of the above method embodiments.

Those skilled in the art will readily conceive of other embodiments of the present application upon consideration of the specification and practice of the invention disclosed herein. The present application is intended to cover any variations, uses, or adaptive changes of the present application that follow the general principles of the present application and include common knowledge or customary technical means in the art not disclosed in the present application. The specification and embodiments are to be regarded as exemplary only, and the true scope and spirit of the present application is indicated by the following claims.

It should be understood that the present application is not limited to the precise structure which has been described above and illustrated in the accompanying drawings, and that various modifications and alterations may be made without departing from its scope. The scope of the present application is limited only by the appended claims.

## Claims

1. A battery balancing detection method, comprising:
performing negative pulse discharging on a battery in response to a battery balancing detection instruction; and
determining an unbalancing degree of the battery based on electrical parameters of battery cells in the battery after discharging.

2. The method according to claim 1, wherein said performing negative pulse discharging on a battery comprises:
performing negative pulse discharging of the battery to discharge the battery from a current state of charge (SOC) to a target SOC.

3. The method according to claim 2, wherein the battery is a battery-with-platform, the slope of an SOC-open circuit voltage (OCV) curve corresponding to the battery-with-platform containing an interval having a zero slope; and said performing negative pulse discharging of the battery to discharge the battery from a current state of charge (SOC) to a target SOC comprises:
determining as the target SOC any SOC that is less than the current SOC of the battery within an SOC interval of the curve that has a non-zero slope; and
reducing an SOC of the battery to the target SOC based on negative pulses.

4. The method according to claim 2, wherein the battery is a battery-without-platform, the slope of an SOC-OCV curve corresponding to the battery-without-platform not containing an interval having a zero slope; and said performing negative pulse discharging of the battery to discharge the battery from a current state of charge (SOC) to a target SOC comprises:
selecting as the target SOC any SOC that is less than the current SOC of the battery from an SOC interval constituted by a maximum SOC and a minimum SOC of an operating condition of an electrical device during a first preset duration; and
reducing an SOC of the battery to the target SOC based on negative pulses.

5. The method according to any one of claims 1 to 4, wherein after said performing negative pulse discharging on a battery, the method further comprises:
resting the battery for which the discharging is completed for a second preset duration.

6. The method according to claim 1, wherein said determining an unbalancing degree of the battery based on electrical parameters of battery cells in the battery after discharging comprises:
determining SOC values of the battery cells separately based on voltage values of the battery cells in the battery after discharging; and
determining the unbalancing degree of the battery according to the SOC values of the battery cells.

7. The method according to claim 6, wherein said determining SOC values of the battery cells separately based on voltage values of the battery cells in the battery after discharging comprises:
determining a current temperature of the battery; and
acquiring current SOC values of the battery cells separately from a preset mapping relationship of battery temperatures, SOCs and voltages according to the current temperature and the voltage values of the battery cells.

8. The method according to claim 1, wherein after said determining the unbalancing degree of the battery, the method further comprises:
performing, if the unbalancing degree of the battery is greater than a preset threshold, a balancing operation on the battery using a preset active balancing module or passive balancing module.

9. The method according to claim 1, wherein before said in response to a battery balancing detection instruction, the method further comprises:
triggering the battery balancing detection instruction when the battery is detected to satisfy a first preset abnormality condition, wherein the first preset abnormality condition comprises the battery experiencing a battery cell diving phenomenon or the battery having not undergone a battery balancing detection for more than a third preset duration.

10. The method according to claim 1, wherein before said in response to a battery balancing detection instruction, the method further comprises:
receiving the battery balancing detection instruction sent by a user; or
receiving the battery balancing detection instruction that is sent by a server when it detects that a second preset abnormality condition is satisfied, wherein the second preset abnormality condition comprises the battery experiencing a battery cell diving phenomenon, or a deviation between unbalancing degrees detected by the server and by a device in which the battery is located exceeding a preset value.

11. The method according to claim 1, wherein before said in response to a battery balancing detection instruction, the method further comprises:
determining that an electrical device in which the battery is located is connected to a charging and discharging device.

12. A battery balancing detection apparatus, comprising:
a discharging unit for performing negative pulse discharging on a battery in response to a battery balancing detection instruction; and
a determination unit for determining an unbalancing degree of the battery based on electrical parameters of battery cells in the battery after discharging.

13. An electronic device comprising a memory and a processor, wherein the memory has a computer program stored therein, and the processor is configured to perform the method as claimed in any one of claims 1 to 11 by means of the computer program.

14. A computer-readable storage medium comprising a program stored therein, wherein the program, when run, performs the method as claimed in any one of claims 1 to 11.
